# EUROPEAN PATENT APPLICATION

(11) **EP 3 301 813 A1**
(43) Date of publication of application: **04.04.2018**
(21) Application number: 16191806.5
(22) Date of filing: 30.09.2016
(51) Int. Cl.: H03M 3/02, H03F 3/45

(54) **DELTA SIGMA ANALOG-TO-DIGITAL CONVERTER, RADIO FRONT-END, RADIO RECEIVER, MOBILE TERMINAL AND BASE STATION**

(71) Applicant: Intel IP Corporation, Santa Clara, CA 95054 (US)
(72) Inventor: Kostack, Robert, 01139 Dresden (DE); Naeini, Ashkan, 80689 München (DE)
(74) Representative: 2SPL Patentanwälte PartG mbB

(57) **Abstract**

Examples provide a delta sigma analog-to-digital converter, a radio front-end, a radio receiver, a mobile terminal and a base station. The delta sigma analog-to-digital converter (100) is suitable for a differential radio frequency current signal. The delta sigma analog to digital converter includes an integrator (110) with a differential input for a differential current signal, and a differential output for a differential voltage signal. The delta sigma analog to digital converter further includes a quantizer (120) with a differential input for the differential voltage signal and a differential output for a digitalized signal. The delta sigma analog to digital converter further includes two or more digital-to-analog converters (130), each with a differential input for the digitalized signal and a differential output for a differential feedback current signal, resulting in two or more separate differential feedback current signals. The differential current signal is based on the two or more separate differential feedback current signals and the differential radio frequency current signal.

## Description

### Field

Examples relate to a delta sigma analog-to-digital converter, a radio front-end, a radio receiver, a mobile terminal and a base station.

### Background

High speed signal transmissions are often based on a combination of multiple signals: For example, a carrier signal at a higher frequency may be modulated with an input signal (at a lower frequency) comprising the information to be transmitted at a transmitter, and demodulated at the receiver, to obtain the transmitted information.

### Brief description of the Figures

Some examples of apparatuses and/or methods will be described in the following by way of example only, and with reference to the accompanying figures, in which
- Fig. 1: shows a schematic diagram of a delta sigma analog-to-digital converter 100 for a differential radio frequency current signal;
- Fig. 2: illustrates a block diagram of a radio front-end;
- Fig. 3: shows a block diagram of an architecture of a digital receiver;
- Fig. 4: shows a schematic diagram of a topology of an exemplary bandpass filter;
- Fig. 5: shows a schematic diagram of a topology of a buffer stage;
- Fig. 6: shows a schematic diagram of a voltage amplifier in a band-pass filter;
- Fig. 7: shows a block diagram of a radio receiver;
- Fig. 8: illustrates examples of radio receivers; and
- Fig. 9: shows a diagram of an example mobile transceiver.

### Detailed Description

Various examples will now be described more fully with reference to the accompanying drawings in which some examples are illustrated. In the figures, the thicknesses of lines, layers and/or regions may be exaggerated for clarity.

Accordingly, while further examples are capable of various modifications and alternative forms, some particular examples thereof are shown in the figures and will subsequently be described in detail. However, this detailed description does not limit further examples to the particular forms described. Further examples may cover all modifications, equivalents, and alternatives falling within the scope of the disclosure. Like numbers refer to like or similar elements throughout the description of the figures, which may be implemented identically or in modified form when compared to one another while providing for the same or a similar functionality.

It will be understood that when an element is referred to as being "connected" or "coupled" to another element, the elements may be directly connected or coupled or via one or more intervening elements. If two elements A and B are combined using an "or", this is to be understood to disclose all possible combinations, i.e. only A, only B as well as A and B. An alternative wording for the same combinations is "at least one of A and B". The same applies for combinations of more than 2 Elements.

The terminology used herein for the purpose of describing particular examples is not intended to be limiting for further examples. Whenever a singular form such as "a," "an" and "the" is used and using only a single element is neither explicitly or implicitly defined as being mandatory, further examples may also use plural elements to implement the same functionality. Likewise, when a functionality is subsequently described as being implemented using multiple elements, further examples may implement the same functionality using a single element or processing entity. It will be further understood that the terms "comprises," "comprising," "includes" and/or "including," when used, specify the presence of the stated features, integers, steps, operations, processes, acts, elements and/or components, but do not preclude the presence or addition of one or more other features, integers, steps, operations, processes, acts, elements, components and/or any group thereof.

Unless otherwise defined, all terms (including technical and scientific terms) are used herein in their ordinary meaning of the art to which the examples belong.

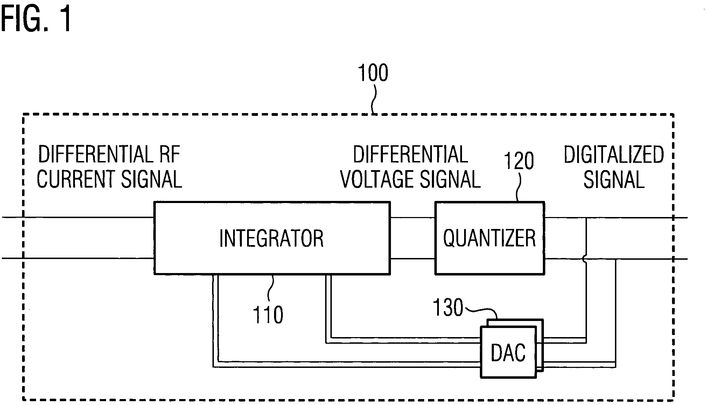

Fig. 1 shows a schematic diagram of a delta sigma analog-to-digital converter 100 for a differential radio frequency current signal. The delta sigma analog-to-digital converter 100 comprises an integrator 110 with a differential input for a differential current signal, and a differential output for a differential voltage signal. The delta sigma analog-to-digital converter further comprises a quantizer 120 with a differential input for the differential voltage signal and a differential output for a digitalized signal. The delta sigma analog-to-digital converter further comprises two or more digital-to-analog converters 130, each with a differential input for the digitalized signal and a differential output for a differential feedback current signal, resulting in two or more separate (e.g. distinguishable) differential feedback current signals. The differential current signal is based on the two or more separate differential feedback current signals and the differential radio frequency current signal.

The delta sigma analog-to-digital converter may enable a sampling of the differential radio frequency current signal in the radio frequency range (e.g. in the transmission band). For example, the delta sigma analog-to-digital converter may be used without a mixer to demodulate the radio frequency signal, and may be implemented without coils. Consequently, the integration complexity and implementation costs may be lowered, resulting in radio frequency receivers with a reduced footprint.

For example, the differential radio frequency current signal may be supplied by a (single-ended to differential) low-noise amplifier (LNA) to the integrator 110. For example, the differential radio frequency current signal may have a (predominant) carrier frequency in the radio frequency range. Directly converting differential radio frequency current signal with a (predominant) carrier frequency in the radio frequency range may enable an analog-to-digital conversion without a requirement for a mixer and a corresponding local oscillator, facilitating a digital implementation. For example, the (predominant) carrier frequency of the differential radio frequency current signal may be in the Ultra High Frequency (UHF, 300 MHz to 3 GHz) or Super High Frequency (SHF, 3 GHz to 30 GHz) range. For example, the (predominant) carrier frequency differential radio frequency current signal may be higher than 300 MHz (or higher than 500 MHz, higher than 750 MHz, higher than 1 GHz, higher than 1.5 GHz, higher than 2 GHz, higher than 3 GHz). For example, the differential radio frequency current signal may have a carrier frequency in a transmission band of the differential radio frequency current signal. For example, the delta sigma analog-to-digital converter 100 may be configured to perform subsampling to obtain the digitalized signal, e.g. to sample at a sub-Nyquist frequency.

For example, the integrator 110 may correspond to or implement a (coil-less) bandpass filter. The bandpass filter may implement the integration portion of the delta sigma analog-to-digital converter, for example. For example, the delta sigma analog-to-digital converter 100 may correspond to a bandpass (type) delta sigma analog-to-digital converter 100, e.g. the integrator of the (bandpass) delta sigma analog to digital converter may be implemented by a bandpass filter. For example, an integration portion of the delta sigma analog-to-digital converter may be performed by a bandpass filter.

For example, the integrator 110 may comprise one or more differential integrator stages (e.g. bandpass stages, gm-filter stages). The integration may be enabled through bandpass filtering. Each differential integrator stage of the one or more differential integrator stages may comprise a resonator, for example. Each integrator stage may comprise two integrators (for the two differential signal branches), for example. For example, the integrator 110 may comprise one or more differential resonator stages. For example, each resonator of the one or more differential integrator stages may comprise an active inductor and a capacitor. The active inductor may improve the performance of the (bandpass) integrator. For example, the active inductor and the capacitor may be coupled to both differential signal branches. For example, the active inductor may comprise one or more transistors; it may for example be based on or comprise one or more transconductors. For example, the active inductor may be based on a gyrator circuit. For example, the integrator 110 may comprise a transconductance (gm) filter with different gm-filter stages for the transconductance amplifiers, and active inductors for better overall performance.

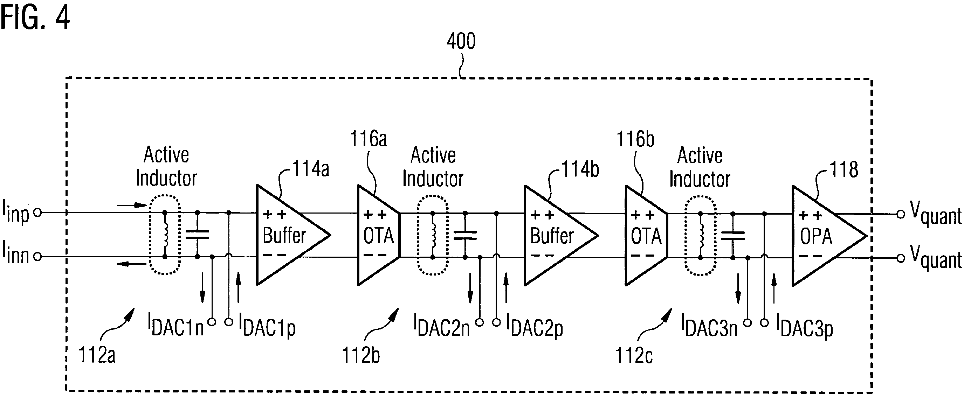

For example, the integrator 110 may comprise two or more differential integrator stages (e.g. two differential integrator stages, three differential integrator stages, four differential integrator stages or more). Fig. 4 shows an exemplary implementation of an integrator comprising three integrator stages.). For example, the two or more differential integrator stages may be serially arranged; the differential current signal may traverse the two or more differential integrator stages. For example, the differential integrator stage located closest to the differential input of the integrator 110 may be denoted as the first integrator stage and the differential integrator stage located closest to the differential output of the integrator 110 may be denoted as the last differential integrator stage. Differential integrator stages in-between may be numbered, e.g. a second differential integrator stage may follow the first differential integrator stage and may be located before the last differential integrator stage (in an integrator 110 comprising three or more differential integrator stages). For example, in an exemplary implementation, a resonant frequency of the resonators of the two or more differential integrator stages may differ. For example, a first resonant frequency of a first resonator of a first earlier integrator stage may be at least 0.5% lower (or at least 1% lower) than a second resonant frequency of a second resonator of a second later integrator stage. Alternatively, a first resonant frequency of a first resonator of a first earlier integrator stage may be at least 0.5% higher (or at least 1% higher) than a second resonant frequency of a second resonator of a second later integrator stage. For example, an implementation of the resonators of the different integrator stages may be substantially equal except for the resonant frequencies. For example, each resonator of the two or more differential integrator stages may have any resonance frequency within a receiving band.

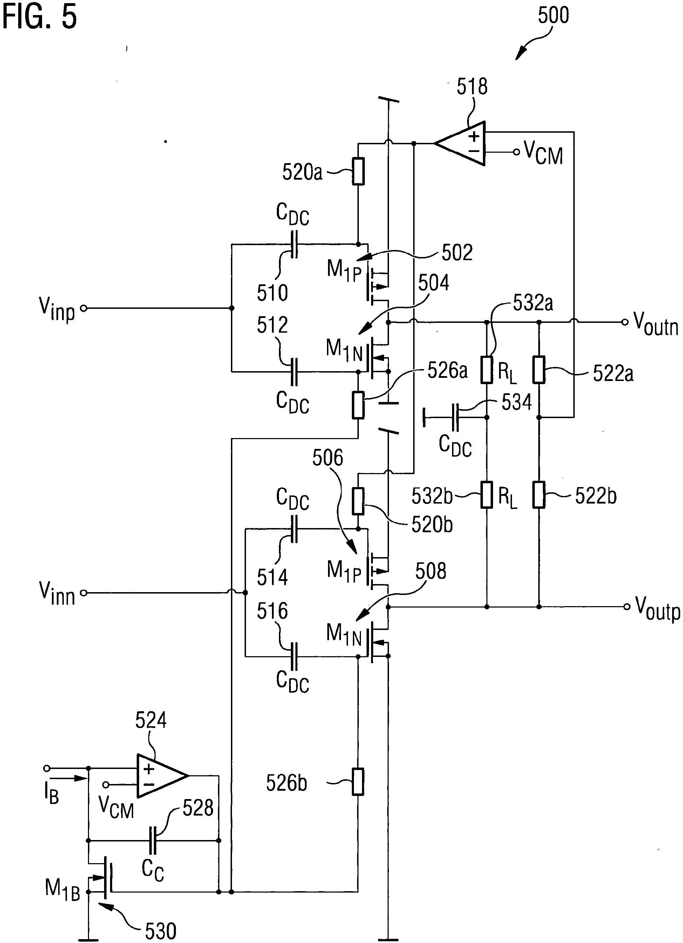

The (resonators of the) two or more differential integrator stages may be separated by differential buffers. The differential buffer (stages) may increase or enable isolation between the integrator stages. For example, the differential buffers may (e.g. in combination with a transconductance amplifier, such as an Operational Transconductance Amplifier (OTA)) buffer a differential current signal, e.g. to supply the differential current signal from one differential integrator stage to the next. For example, an output of a differential buffer may be coupled to a differential transconductance amplifier. The two or more integrator stages may be separated by the differential buffers and the differential transconductance amplifiers. For example, the differential transconductance amplifier may be configured to generate the differential current signal for a subsequent integrator stage based on a differential voltage output of the differential buffer. For example, the differential buffers may be configured to buffer the differential current signal as intermediary differential voltage signal, and the transconductance amplifiers may be configured to convert the intermediary differential voltage signal to a current signal for the following integrator stage. For example, the differential buffers may each comprise a differential inverter structure with a regulated common-mode output voltage, e.g. to achieve ~0dB differential gain. (The differential transconductance of each OTA may differ from each other and does not have to be 1) Fig. 5 shows an exemplary implementation of a differential buffer.

For example, the two or more digital-to-analog converters 130 may be configured to provide the two or more separate differential feedback current signals as current representation of the digitalized signal, providing the feedback portion of the delta sigma analog-to-digital converter. For example, the two or more digital-to-analog converters 130 may comprise at least two differential digital-to-analog converters for each integrator stage of the integrator 110. Consequently, the two or more digital-to-analog converters 130 may comprise at least two separate differential feedback current signals for each differential integrator stage of the integrator 110. For example, the two or more digital-to-analog converters 130 may comprise two or more (at least partially) separate digital-to-analog converters, e.g. separate current mirrors for each of the two or more digital-to-analog converters 130. For example, the at least two separate differential feedback current signals for each differential integrator stage might (only) be combined in the resonator of said integrator stage, and kept separate of differential feedback current signals for other integrator stages.

In at least some examples, the number of differential digital-to-analog converters of the two or more digital-to-analog converters 130 may be the number of integrator stages plus one (e.g. generating one distinguishable/separate feedback signal for each integrator and one additional separate/distinguishable feedback signal for each integrator of the last integrator stage). Alternatively, the number of differential digital-to-analog converters of the two or more digital-to-analog converters 130 may be at least (e.g. exactly) twice the number of differential integrator stages plus one. Two differential feedback current signals for the resonator of each integrator stage and an additional differential feedback current signal for the last integrator stage may enable a stable operation of the bandpass sigma delta analog-to-digital converter. For example, the two or more digital-to-analog converters may comprise at least two differential digital-to-analog converters for each integrator stage. The at least two differential digital-to-analog converters for each integrator stage may have mutually different pulse-shaping properties (e.g. one non-return-to-zero and one return-to-zero). For example, each differential digital-to-analog converter of the at least two differential digital-to-analog converters having mutually different pulse-shaping properties may be configured to provide the separate (distinguishable) differential feedback current signal for the resonator of its respective integrator stage. The at least two differential digital-to-analog converters for each integrator stage having mutually different pulse-shaping properties may further stabilize the integrator during operation. For example, in an exemplary implementation, the two or more digital-to-analog converters 130 may comprise at least one differential non-return-to-zero digital-to-analog converter and at least one differential return-to-zero digital-to-analog converter for each integrator stage, e.g. to compensate for non-ideal properties of the integrator. For example, each differential digital-to-analog converter of the at least one differential non-return-to zero digital-to-analog converter and the at least one differential return-to-zero digital-to-analog converter for each integrator stage may be configured to provide the separate differential feedback current signal for its respective integrator stage. For example, a p (positive) signal branch of a differential output of a digital-to-analog converter of the two or more digital-to-analog converters 130 may be coupled to a p signal branch of the resonator of the respective differential integrator stage (analog for the n (negative) signal branch). For example, in a resonator of an integrator stage, the p signal branch of the differential current signal at that integrator stage, the n signal branch of the differential current feedback signal of the differential return-to-zero digital-to-analog converter for that integrator stage and the p signal branch of the differential current feedback signal of the differential non-return-to-zero digital-to-analog converter for that integrator stage may be coupled (analog for the n signal branch). For example, the at least one differential non-return-to-zero digital-to-analog converter and the at least one differential return-to-zero digital-to-analog converter for each integrator stage may be delayed by a half clock cycle compared to the analog quantizer input signal.

For example, in an exemplary implementation, for each integrator stage, the differential return-to-zero digital-to-analog converter for the integrator stage may provide approximately twice (e.g. 160% - 240%) the (average or maximal) current of the differential non-return-to-zero digital-to-analog converter, over half the clock cycle (resulting in approximately the same net current). For example, a ratio of (average or maximal) currents of the NRZ and RZ DACs may be dependent of coefficients of an ideal model of the circuit, and may be different for each integrator stage (e.g. not 1:1). For example, a combination of the differential feedback current signal of the differential non-return-to-zero digital-to-analog converter and of the differential return-to-zero digital-to-analog converter may result in an approximate single negative net current in the first half of a clock cycle and in a single net current in the second half (or vice versa). For example, a maximal output current (and corresponding footprint) of a differential digital-to-analog converter of a second later integrator stage may be at least 20% higher (or at least 30% higher, at least 40% higher, at least 50% higher) than a maximal current (and corresponding footprint) for a differential digital-to-analog converter of a first, earlier integrator stage of the respective (return-to-zero or non-return-to-zero) differential digital-to-analog converter type. For example, a resolution of a differential digital-to-analog converter of a second later integrator stage may be at least 20% higher (or at least 30% higher, at least 40% higher, at least 50% higher) than a resolution of a differential digital-to-analog converter of a first, earlier integrator stage of the respective (return-to-zero or non-return-to-zero) differential digital-to-analog converter type.

For example, the two or more digital-to-analog converters 130 may (additionally) comprise one differential non-return-to-zero digital-to-analog converter being delayed by a half clock cycle compared to other differential digital-to-analog converters of the two or more digital-to-analog converters 130. The one non-return-to-zero differential digital-to-analog converter may be configured to provide its differential feedback current signal for the last integrator stage of the one or more integrator stages, e.g. to compensate for excess loop delay.

The differential current signal is based on the two or more separate differential feedback current signals and the differential radio frequency current signal. For example, for the first integrator stage (or only) integrator stage, the resonator may be coupled to the differential radio frequency current signal and the two or more (or at least two) differential feedback current signals for the first stage. For a subsequent integrator stage, the resonator may be coupled to the output current of the previous stage (e.g. provided by the differential buffer / differential transconductance amplifier) and the two or more (or at least two) differential feedback current signals for that subsequent stage.

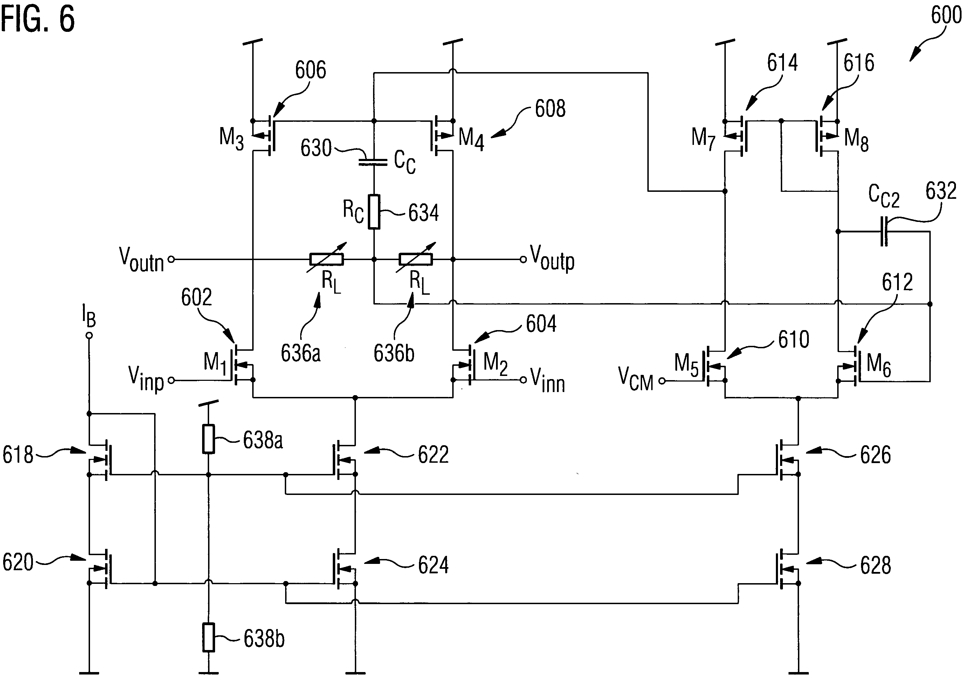

For example, the integrator 110 may comprise a differential voltage amplifier at the output of the integrator 110 to generate the differential voltage signal. For example, the differential voltage amplifier may convert the differential signal of the last integrator stage into the differential voltage signal. For example, the differential voltage amplifier may comprise an adjustable gain. The differential voltage amplifier may help relax the requirement on the internal resistance of the resonator of the last integrator stage and its maximal allowed output voltage swing, for example. For example, the differential voltage amplifier may correspond to a fully differential amplifier comprising a cascode structure as current source, which may enable a higher output resistance. Fig. 6 shows an exemplary implementation of a differential voltage amplifier according to an example.

For example, the quantizer 120 may correspond to a multibit quantizer. Alternatively, the quantizer 120 may correspond to a single-bit quantizer. For example, an oversampling rate of the delta sigma analog to digital converter 100 may be sub-Nyquist, e.g. less than twice the frequency of the carrier signal of the differential radio frequency current signal. For example, the quantizer 120 may be configured to provide a multibit digital approximation of the differential voltage signal. For example, the differential output of the quantizer 120 may provide a quantized version for the two branches of the differential voltage signal. For example, the quantizer may provide at least a 2 bit (or at least 4 bit, at least 8 bit, at least 12 bit, at least 16 bit) wide digital approximation of the differential voltage signal (as output width).

For example, the differential digital-to-analog converters of the two or more digital-to-analog converters 130 may correspond to multibit differential digital-to-analog converters. An input width of the differential digital-to-analog converters of the two or more digital-to-analog converters 130 may correspond to an output width of the multibit quantizer.

A differential signal (e.g. the differential radio frequency current signal, the differential current signal, the differential feedback current signals and the differential voltage signal) may correspond to or comprise two signals with opposite polarity. For example, a differential input (e.g. the differential input of the integrator) may comprise or correspond to two inputs for the two polarities of a differential signal. For example, a differential output (e.g. the differential output of the integrator) may correspond to two outputs for the two polarities of a differential signal. A signal denoted as current signal (e.g. the differential radio frequency current signal, the differential current signal, and the differential feedback current signals) may for example correspond to a signal that conveys information through differing currents, e.g. the current may change depending on the (information) content of the signal. A signal denoted as voltage signal (e.g. the differential voltage signal) may for example correspond to a signal that conveys information through differing voltages, e.g. the voltage may change depending on the (information) content of the signal.

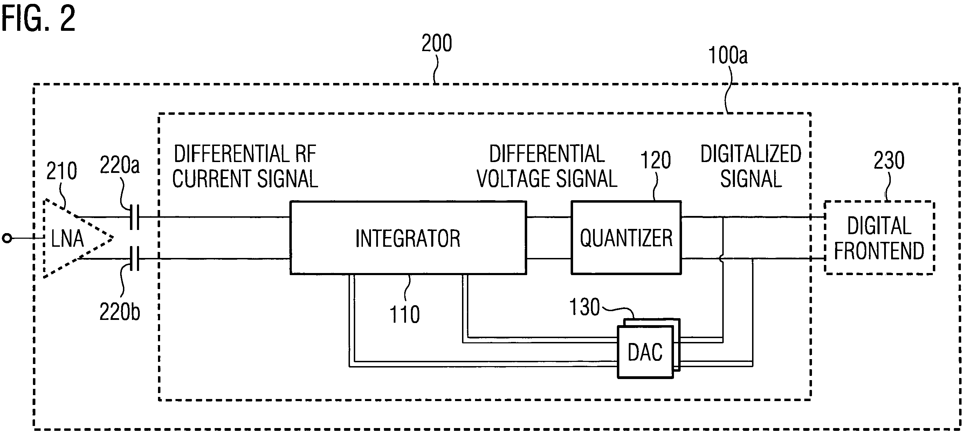

Fig. 2 illustrates a block diagram of a radio front-end (analog-to-digital converter) 200 comprising a delta sigma analog-to-digital converter 100a according to an example. The delta sigma analog-to-digital converter 100a may be implemented similar to the delta sigma analog-to-digital converter described in connection with Fig. 1. The delta sigma analog-to-digital converter comprises an integrator 110 with a differential input for a differential current signal, and a differential output for a differential voltage signal. The delta sigma analog-to-digital converter further comprises a quantizer 120 with a differential input for the differential voltage signal and a differential output for a digitalized signal. The delta sigma analog-to-digital converter further comprises two or more digital-to-analog converters 130, each with a differential input for the digitalized signal and a differential output for a differential feedback current signal, resulting in two or more separate differential feedback current signals. The differential current signal is based on the two or more separate differential feedback current signals and the differential radio frequency current signal.

The radio front-end 200 may be configured to sample (perform an analog-to-digital conversion) a (radio frequency) radio signal without using a mixer. For example, the analog-to-digital conversion within the analog-to-digital converter 200 may be performed in the frequency range of the transmission band, and the demodulation and decoding of the signal may be performed in a digital front-end 230.

A radio front-end with such a delta sigma analog-to-digital converter may enable a sampling of the differential radio frequency current signal in the radio frequency range. For example, the radio front-end may be used without a mixer to demodulate the radio frequency signal, and may be implemented without coils. Consequently, an integration complexity and implementation costs may be lowered, resulting in radio frequency receivers with a reduced footprint.

For example, the radio front-end 200 may comprise a single-ended to differential low-noise amplifier 210 configured to provide the differential radio frequency current signal. Using a single-ended to differential low-noise amplifier may facilitate an integration, as only one signal interface (e.g. to an Antenna) may be necessary. For example, the single-ended to differential low-noise amplifier 210 may comprise a first amplification stage configured to amplify an input signal, Vin(t), to obtain an intermediate signal, a cascoding circuit configured to amplify the intermediate signal to obtain a first output signal Vₒᵤₜₙ(t) and a second amplification stage configured to amplify the intermediate signal to obtain a second output signal, Vₒᵤₜₚ(t). The first and second output signals, Vₒᵤₜₙ(t), Vₒᵤₜₚ(t), may form a differential output, which may correspond to the differential radio frequency signal, which may become the differential radio frequency current signal in combination with decoupling capacitors 220a; 220b. For example, one of the first amplification stage and the second amplification stage may be an inverting amplification stage and the other may be a non-inverting amplification stage. The first amplification stage may comprise a first push-pull stage cascoded with the cascoding circuit; the second amplification stage may comprise a second push-pull stage configured to amplify the intermediate signal.

For example, the radio front-end 200 may further comprise a decoupling capacitor 220a; 220b for each differential signal branch of the differential radio frequency current signal between the single-ended to differential low-noise amplifier 210 and the integrator 110. The decoupling capacitors may be used to reduce or prevent an interaction between the single-ended to differential low-noise amplifier 210 and the integrator 110, for example.

For example, the radio front-end may further comprise a digital frontend 230 with an input for the digital voltage signal. The digital frontend 230 may be configured to demodulate (e.g. and process) the digital voltage signal from the radio frequency / transmission band frequency range, for example.

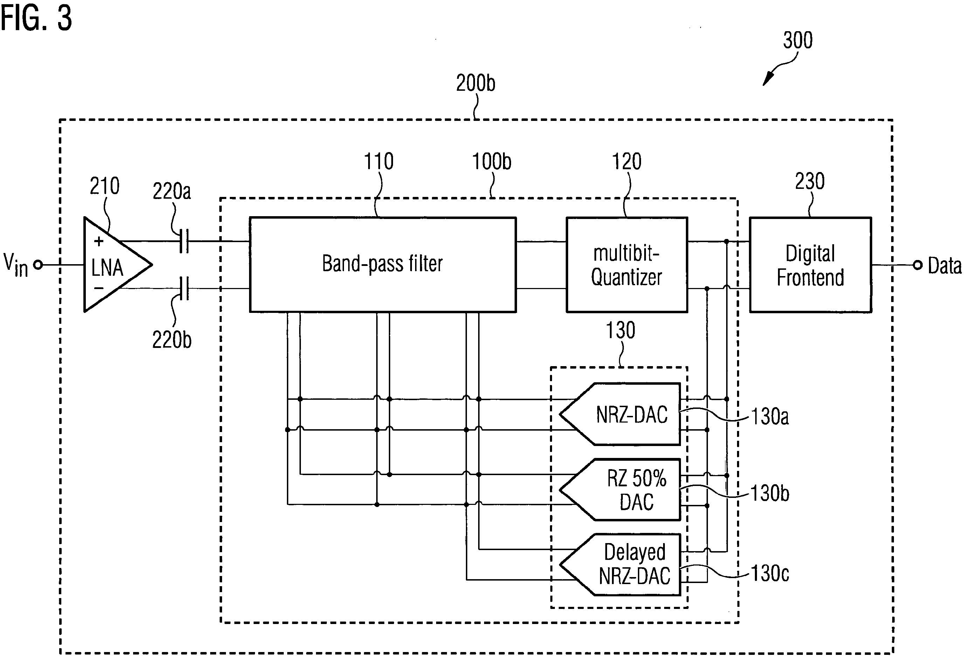

More details and aspects are mentioned in connection with the examples described above or below. The example shown in Fig. 2 may comprise one or more optional additional features corresponding to one or more aspects mentioned in connection with the proposed concept or one or more examples described above (e.g. Fig. 1) or below (e.g. Fig. 3-9).

At least some examples relate to a coil-less digital direct receiver architecture and parts thereof. Various examples relate to a digital receiver design topology suited for modern receiver requirements. This digital receiver may comprise or consist (only) of a single-ended to differential LNA (Low-Noise Amplifier, e.g. the single-ended to differential low-noise amplifier 210 of Fig. 2) and a band-pass sigma-delta ADC (Analog-to-Digital Converter, e.g. the delta sigma analog-to-digital converter 100 of Fig. 1) and the appropriate clock generation, but the usual existing IQ-mixer (In-phase and Quadrature mixer), the analog baseband filtering and very power consuming LO (Local Oscillator) distribution might be omitted, so the overall power consumption, the receiver complexity and chip area may be reduced. Furthermore, the IQ differentiation may take place in the digital domain, so only one ADC may be required to quantize the received RF (Radio Frequency) signal. Additionally, to save overall power consumption of ADC block and digital signal processing, sub(Nyquist)-sampling may be applied to down mix the received signal; this may avoid the need for a higher sampling frequency. At least some examples may use active and coil-less high-Q filters in a band-pass sigma-delta-ADC to achieve a high dynamic range and a high Signal-to-Noise-Ratio. Avoiding a usage of coils may enable a fully digital process at reduced semiconductor scales.

A subsampling system may show a lower oversampling rate than Nyquist systems, which may result in a lower overall SNR (Signal-to-Noise-Rati) of the ADC. This may be compensated by using a higher order SD (Sigma Delta) ADC with a very high-Q (high Quality factor) active band-pass filter or increasing significantly the quantization bits to enable an achievement of receiver sensitivity requirements of modern communication systems.

Some examples described here may provide a receiver that samples the RF received signal directly without down modulating to baseband frequency. Further signal processing may be accomplished in the digital domain. This may provide a receiver architecture with flexibility for modern cellular applications, while using less area and reducing the overall power consumption compared to other systems.

This digital receiver might only use one input port and convert the signal received at the one input port to a differential signal without the usage of large passive transformers. The receiver might not use a mixer to down convert the signal but rather may use the ADC sampler via sub-sampling to mix the signal to lower frequencies and to concurrently digitize it.

The active high Q resonators in the band-pass loop filter may shape effectively the noise out of the received wanted bandwidth. A current domain filter design may avoid high voltage drops inside the filter and may allow for a high dynamic at low current consumption.

The application of an additional voltage amplifier may increase the full-scale and dynamic range of the ADC. No use of a local oscillator and in-phase / quadrature local oscillator generation may simplify the clock distribution. All of these techniques may save power, area and design complexity.

The topology of an example receiver 300 is shown in Fig. 3 below. Fig. 3 may show an architecture of a digital receiver. The receiver 300 comprises a radio front-end 200b comprising a delta sigma analog-to-digital converter 100b. The radio front-end 200b may be implemented similar to a radio front-end as introduced in connection with Fig. 2. The delta sigma analog-to-digital converter 100b may be implemented similar to a delta sigma analog-to-digital converter as introduced in connection with Fig. 1 It may use a band-pass sigma-delta ADC 100b and single-ended to differential LNA 210 while forgoing the mixer and LO. The ADC 100b may comprise a multibit-quantizer 120 and a higher (6th) order high-Q active coil-less band-pass filter 110 (as integrator) to achieve high SQNR (Signal-to-Quantization-Noise-Ratio). A filter of higher order, e.g. of 6th order, may require 6 DAC (Digital-to-Analog-Converter) feedbacks in the ADC plus one additional DAC to compensate the Excess Loop Delay (ELD), which may be realized using 2 different types of feedback DAC (for the two or more digital-to-analog converters 130): 3 Non-Return-to-Zero (NRZ) DACs 130a and 3 Return-to-Zero (RZ) DACs 130b, respectively, with 0.5*T loop delay and 1 NRZ-DAC 130c with 1*T loop delay. In order to prevent an LNA and band-pass filter interaction with each other at DC-level, an AC-coupling 220a, 220b may be implemented at the LNA 210 output. The differential output of the multibit quantizer 120 may be used for the DACs 130 and may be input into a digital frontend 230 of the radio front-end 200b.

Particularly, stabilization of a RF high gain band-pass filter as loop filter may be challenging, since the isolation of each stage of filter to each other may play an important role. With insufficient isolation, the transfer functions of the single filters may be (heavily) distorted, leading to a non-functional and oscillating ADC.

More details and aspects are mentioned in connection with the examples described above or below. The example shown in Figs. 3 may comprise one or more optional additional features corresponding to one or more aspects mentioned in connection with the proposed concept or one or more examples described above (e.g. Fig. 1-2) or below (e.g. Fig. 4-9).

Fig. 4 shows a schematic diagram of a topology of an exemplary bandpass filter 400, which may implement an integrator 110 as described in connection with Fig. 1. It may comprise a gm filter (transconductance filter) which uses different gm-stages for the OTAs (Operational Transconductance Amplifiers) and active inductors for better overall performance. In order to avoid having to use cascode structures in the OTA, which may reduce the linearity and therefore dynamic range of the receiver because of the low supply voltage of 1.1V, additional buffer stages for isolation between the filter nodes may be applied.

The bandpass filter 400 comprises three filter stages (integrator stages) 112a; 112b; 112c, which a separated by differential buffers 114a; 114b and differential transconductance amplifiers 116a; 116b. At the output of the bandpass filter 400, a (fully) differential voltage amplifier (operational amplifier) 118 may be configured to provide the voltage signal. The differential buffers 112a; 114b may be configured to buffer the currents of the filter stages (as voltage) and output them, via the OTAs 116a; 116b to the subsequent filter stage. The buffers/OTAs may be configured to decouple or isolate the filter stages.

More details and aspects are mentioned in connection with the examples described above or below. The example shown in Fig. 4 may comprise one or more optional additional features corresponding to one or more aspects mentioned in connection with the proposed concept or one or more examples described above (e.g. Figs. 1-3) or below (e.g. Fig. 5-9).

An exemplary design of the Buffer stage is shown in Fig. 5, which may show a buffer topology for additional isolation. Fig. 5 may show a differential buffer 500 comprising a differential inverter structure with a regulated common-mode output voltage and a resistive load R_{L} to achieve ~0dB differential gain. The differential buffer 500 comprises enhancement type p-channel MOSFETs (Metal-Oxide-Semiconductor Field Effect Transistors) M₁ₚ 502; 506 and depletion type n-channel MOSFETs M₁ₙ 504; 508, each with corresponding source, drain and gate connectors. The differential buffer 500 further comprises decoupling capacitors C_{DC} 510-516. The input Vᵢₙₚ (positive branch of the differential input) is coupled to the decoupling capacitors 510 and 512 and the input Vᵢₙₙ (negative branch of the differential input) is coupled to the decoupling capacitors 514 and 516. Decoupling capacitor 510 is further coupled to the gate of p-channel MOSFET 502, decoupling capacitor 512 is further coupled to the gate connector of n-channel MOSFET 504, decoupling capacitor 514 is further coupled to the gate connector of p-channel MOSFET 506, and decoupling capacitor 516 is further coupled to the gate connector of n-channel MOSFET 508. The differential buffer 500 further comprises operational amplifiers 518 and 524, each with a positive and a negative input and an output. The negative inputs of both operational amplifiers 518 and 524 are coupled to the common mode voltage V_{CM}. The positive input of operational amplifier 518 is coupled to a voltage divider made up of resistors 522a and 522b. Resistor 522a is coupled to Vₒᵤₜₙ (negative branch of the differential output), which is coupled to the drain connector of the MOSFETs 502 and 504, and resistor 522b is coupled to Vₒᵤₜₚ (positive branch of the differential output), which is coupled to the drain connector of the MOSFETs 506 and 508. The output of operational amplifier 518 is coupled to the gate connector of p-channel MOSFET 502 via a resistor 520a, and to the gate connector of p-channel MOSFET 506 via a resistor 520b. The positive input of operational amplifier is coupled to bias current I_{B}, a drain connector of a depletion-type n-channel MOSFET M_{1B} 530 and to a capacitor 528. The capacitor 528 and the gate connector of the n-channel MOSFET 530 are further coupled to the output of operational amplifier 524. The output of operational amplifier is coupled to the gate connector of the n-channel MOSFET 504 via a resistor 526a and to the gate connector of the n-channel MOSFET 508 via a resistor 526b. The buffer 500 further comprises a further voltage divider between Vₒᵤₜₙ and Vₒᵤₜₚ, made up of resistors R_{L} 532a and 532b. The voltage divider is coupled to decoupling capacitor C_{DC} 534. Decoupling capacitor C_{DC} 534 is further coupled to a reference, e.g. ground. The source connectors of n-channel MOSFETs 504, 508 and 530 are further coupled to the reference. The source connectors of p-channel MOSFETs 502 and 506 are coupled to the supply voltage.

More details and aspects are mentioned in connection with the examples described above or below. The example shown in Fig. 5 may comprise one or more optional additional features corresponding to one or more aspects mentioned in connection with the proposed concept or one or more examples described above (e.g. Fig. 1-4) or below (e.g. Figs. 6-9).

The bandpass filter (of the integrator 110) may comprise the voltage amplifier at the output of the band-pass filter to relax the voltage gain requirement of the last filter stage in the sigma-delta-ADC 100. An exemplary topology is shown in Fig. 6. Fig. 6 shows a circuit diagram of a voltage amplifier in the band-pass filter according to an example. The voltage amplifier 600 comprises enhancement type n-channel MOSFETs M1 602, M2 604, M5 610, M6 612, 618, 620, 622, 624, 626 and 628 and depletion type p-channel MOSFETs M3 606, M4 608, M7 614 and M8 616, each with gate, source and drain connectors. The voltage amplifier 600 further comprises capacitors Cc 630 and C_{C2} 632, resistors RC 634, 638a and 638b and adjustable resistors 636a and 636b. The gate of MOSFET M1 602 is coupled to Vᵢₙₚ (positive branch of the differential input) and the gate of MOSFET M2 602 is coupled to Vᵢₙₙ (negative branch of the differential input). Vₒᵤₜₚ (positive branch of the differential output) is coupled to the drain connectors of MOSFETs M1 602 and M3 606, Vₒᵤₜₙ (negative branch of the differential output) is coupled to the drain connectors of MOSFETs M2 604 and M4 608. The source connectors of M1 602 and M2 604 are coupled to the drain connector of MOSFET 622, which forms a cascode with MOSFET 624 (the source connector of MOSFET 622 is coupled to the drain connector of MOSFET 624). The source connectors of M5 610 and M6 612 are coupled to the drain connector of MOSFET 626, which forms a cascode with MOSFET 628 (the source connector of MOSFET 626 is coupled to the drain connector of MOSFET 628). The drain connector of MOSFET 618 is coupled to a bias current I_{B}, and the source connector of MOSFET 618 is coupled to the drain connector of MOSFET 620. The gate connectors of MOSFETS 620, 624 and 624 are coupled to I_{B}, and the gate connectors of MOSFETs 618, 622 and 626 are coupled to a voltage divider formed between the supply voltage and a reference (e.g. ground) by the resistors 638a and 638b. The source connectors of the MOSFETs 620, 624 and 628 are coupled to the reference (e.g. ground). The source connectors of M3 606, M4 608, M7 614 and M8 616 are coupled to the supply voltage. The gate connectors of M3 606 and M4 608 are coupled to the drain connectors of M5 610 and M7 810 and to the capacitor C_{c} 630. The gate connectors of M7 614 and M8 616 are coupled to the drain connectors of M6 612 and M8 616. The gate connector of M6 612 is coupled to the capacitor C_{C2} 632, to a voltage divider formed by the adjustable resistors R_{L} between Vₒᵤₜₙ (636a) and Vₒᵤₜₚ (636b) and to the capacitor Cc 630 via resistor R_{C} 634. Capacitor C_{C2} is further coupled to the drain connectors of M6 612 and M8 616. The gate connector of M5 610 is coupled to the common mode voltage V_{CM}.

M1 602 and M2 604 may form the differential pair of this fully differential amplifier. M5 to M8 (610-616) may depict the common-mode regulation and with R_{L} 636a; 636b, the gain may be adjusted. R_{C} 634, Cc 630 and C_{C2} 623 may be used to stabilize the regulation. The current source of the amplifier may be designed as cascode for higher output resistance. The effect on linearity using a cascode in the current source may be negligibly small.

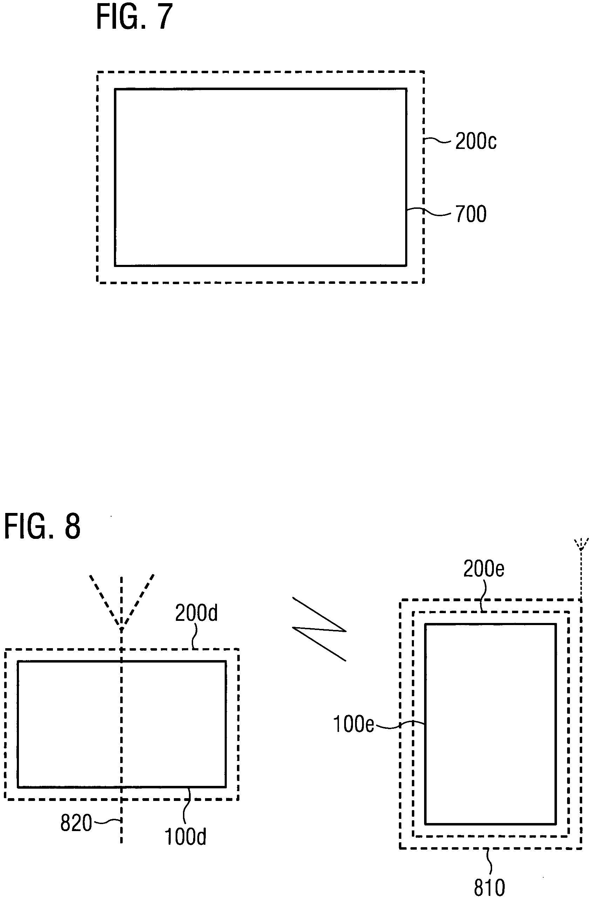

More details and aspects are mentioned in connection with the examples described above or below. The example shown in Fig. 6 may comprise one or more optional additional features corresponding to one or more aspects mentioned in connection with the proposed concept or one or more examples described above (e.g. Fig. 1-5) or below (e.g. Fig. 7-9).

Further examples are shown in Fig. 7 to 9. Fig. 7 shows a block diagram of a radio receiver 700 (e.g. of a mobile transceiver, a mobile terminal, a mobile device, a stationary device, of a wireless access point or of a base station transceiver) comprising a radio front-end 200c. The radio front-end 200c may be implemented similar to a radio front-end described in connection with Fig. 2. A radio receiver with such a radio front-end with a delta sigma analog-to-digital converter may enable a sampling of the differential radio frequency current signal in the radio frequency range. For example, the radio receiver may be used without a mixer to demodulate the radio frequency signal, and may be implemented without coils. Consequently, an integration complexity and implementation costs may be lowered, resulting in radio frequency receivers with a reduced footprint.

More details and aspects are mentioned in connection with the examples described above or below. The example shown in Fig. 7 may comprise one or more optional additional features corresponding to one or more aspects mentioned in connection with the proposed concept or one or more examples described above (e.g. Fig. 1-6) or below (e.g. Fig. 8-9).

Fig. 8 illustrates examples of radio receivers 810, 820 in general, e.g. a mobile transceiver 810 and a base station transceiver 820. Fig. 8 shows an example of a mobile transceiver 810 comprising an example of radio front-end 200d comprising a delta sigma analog-to-digital converter 100d. Fig. 8 further shows an example of a base station transceiver 820 comprising an example of radio front-end 200e comprising a delta sigma analog-to-digital converter 100e. The radio front-ends 200d and/or 200e may be implemented similar to a radio front-end described in connection with Fig. 2. The delta sigma analog-to-digital converters 100d and/or 100e may be implemented similar to a delta sigma analog-to-digital converter described in connection with Fig. 1. The mobile transceiver 810 and the base station transceiver 820 form a mobile communication system, which is another example. The mobile communication system may correspond, for example, to one of the Third Generation Partnership Project (3GPP)-standardized mobile communication networks, where the term mobile communication system is used synonymously to mobile communication network. The mobile or wireless communication system may correspond to a mobile communication system of the 5th Generation (5G) and may use mm-Wave technology. The mobile communication system may correspond to or comprise, for example, a Long-Term Evolution (LTE), an LTE-Advanced (LTE-A), High Speed Packet Access (HSPA), a Universal Mobile Telecommunication System (UMTS) or a UMTS Terrestrial Radio Access Network (UTRAN), an evolved-UTRAN (e-UTRAN), a Global System for Mobile communication (GSM) or Enhanced Data rates for GSM Evolution (EDGE) network, a GSM/EDGE Radio Access Network (GERAN), or mobile communication networks with different standards, for example, a Worldwide Inter-operability for Microwave Access (WIMAX) network IEEE 802.16 or Wireless Local Area Network (WLAN) IEEE 802.11, generally an Orthogonal Frequency Division Multiple Access (OFDMA) network, a Time Division Multiple Access (TDMA) network, a Code Division Multiple Access (CDMA) network, a Wideband-CDMA (WCDMA) network, a Frequency Division Multiple Access (FDMA) network, a Spatial Division Multiple Access (SDMA) network, etc.

A base station or base station transceiver 820 can be operable to communicate with one or more active mobile transceivers 810 and a base station transceiver 820 can be located in or adjacent to a coverage area of another base station transceiver, e.g. a macro cell base station transceiver or small cell base station transceiver. Hence, examples may provide a mobile communication system comprising one or more mobile transceivers 810 and one or more base station transceivers 820, wherein the base station transceivers 820 may establish macro cells or small cells, as e.g. pico-, metro-, or femto cells. A mobile transceiver 810 may correspond to a smartphone, a cell phone, user equipment, a laptop, a notebook, a personal computer, a Personal Digital Assistant (PDA), a Universal Serial Bus (USB) -stick, a car, etc. A mobile transceiver 810 may also be referred to as User Equipment (UE) or mobile in line with the 3GPP terminology.

A base station transceiver 820 can be located in the fixed or stationary part of the network or system. A base station transceiver 820 may correspond to a remote radio head, a transmission point, an access point, a macro cell, a small cell, a micro cell, a femto cell, a metro cell etc. A base station transceiver 820 can be a wireless interface of a wired network, which enables transmission of radio signals to a UE or mobile transceiver 810. Such a radio signal may comply with radio signals as, for example, standardized by 3GPP or, generally, in line with one or more of the above listed systems. Thus, a base station transceiver 820 may correspond to a NodeB, an eNodeB, a Base Transceiver Station (BTS), an access point, a remote radio head, a transmission point etc., which may be further subdivided in a remote unit and a central unit.

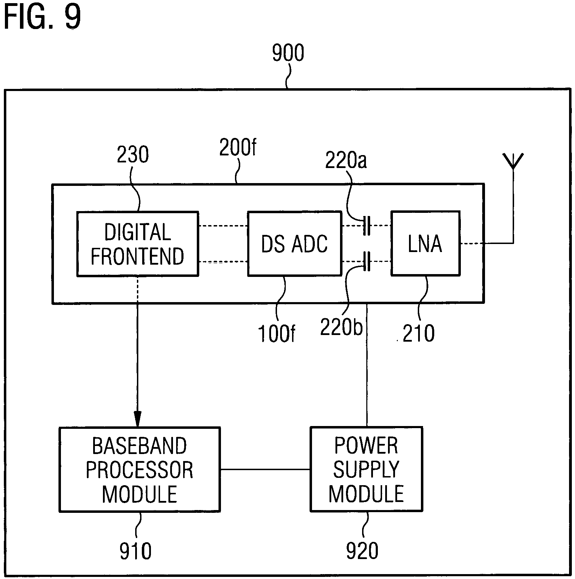

More details and aspects are mentioned in connection with the examples described above or below. The example shown in Figs. 8 may comprise one or more optional additional features corresponding to one or more aspects mentioned in connection with the proposed concept or one or more examples described above (e.g. Fig. 1-7) or below (e.g. Fig. 9).

Fig. 9 shows a block diagram of a mobile transceiver 900, which comprises a radio front-end 200f (which may be implemented similar to a radio front-end as introduced in connection with Fig. 2), a baseband processor module 910 and a power supply module 920. As exemplified in Fig. 9 an antenna is coupled to the radio front-end 200f, which comprises an example of an a delta sigma analog-to-digital converter 100f (which may be implemented similar to the delta sigma analog-to-digital converter as introduced in connection with Fig. 1). The out-put of the digital frontend 230 of the radio front-end 200f is provided to the baseband processor module 910. The baseband processor module 910 is configured to further process the baseband receive signal. Additionally, the mobile transceiver comprises a power supply unit 920 supplying at least the radio front-end 200f and the baseband processor module 920 with power.

More details and aspects are mentioned in connection with the examples described above or below. The example shown in Fig. 9 may comprise one or more optional additional features corresponding to one or more aspects mentioned in connection with the proposed concept or one or more examples described above (e.g. Fig. 1-8) or below.

The aspects and features mentioned and described together with one or more of the previously detailed examples and figures, may as well be combined with one or more of the other examples in order to replace a like feature of the other example or in order to additionally introduce the feature to the other example.

The examples as described herein may be summarized as follows:
A first example is a delta sigma analog-to-digital converter 100 for a differential radio frequency current signal. The delta sigma analog-to-digital converter 100 comprises an integrator 110 with a differential input for a differential current signal, and a differential out-put for a differential voltage signal. The delta sigma analog-to-digital converter 100 further comprises a quantizer 120 with a differential input for the differential voltage signal and a differential output for a digitalized signal. The delta sigma analog-to-digital converter 100 further comprises two or more digital-to-analog converters 130, each with a differential input for the digitalized signal and a differential output for a differential feedback current signal, resulting in two or more separate differential feedback current signals. The differential current signal is based on the two or more separate differential feedback current signals and the differential radio frequency current signal.
In example 2, the integrator 110 comprises one or more differential integrator stages, wherein each differential integrator stage of the one or more differential integrator stages comprises a resonator.
In example 3, each resonator of the one or more differential integrator stages comprises an active inductor and a capacitor.
In example 4, the integrator 110 comprises two or more differential integrator stages, wherein the two or more differential integrator stages are separated by differential buffers.
In example 5, an output of a differential buffer is coupled to a differential transconductance amplifier, wherein the two or more integrator stages are separated by the differential buffers and the differential transconductance amplifiers, and wherein the differential transconductance amplifier is configured to generate the differential current signal for a subsequent integrator stage based on a differential voltage output of the differential buffer.
In example 6, the differential buffers each comprise a differential inverter structure with a regulated common-mode output voltage.
In example 7, the number of digital-to-analog converters of the two or more digital-to-analog converters 130 is at least twice the number of differential integrator stages plus one.
In example 8, the two or more digital-to-analog converters 130 comprise at least two differential digital-to-analog converters for each integrator stage, wherein the at least two differential digital-to-analog converters for each integrator stage have mutually different pulse-shaping properties.
In example 9, each differential digital-to-analog converter of the at least two differential digital-to-analog converters having mutually different pulse-shaping properties is configured to provide the separate differential feedback current signal for the resonator of its respective integrator stage.
In example 10, the two or more digital-to-analog converters 130 comprise one differential non-return-to-zero digital-to-analog converter being delayed by a half clock cycle compared to other differential digital-to-analog converters of the two or more digital-to-analog converters 130, wherein the one non-return-to-zero differential digital-to-analog converter is configured to provide the differential feedback current signal for the last integrator stage of the one or more integrator stages.
In example 11, the integrator 110 comprises a differential voltage amplifier at the output of the integrator 110 to generate the differential voltage signal.
In example 12, the differential voltage amplifier corresponds to a fully differential amplifier comprising a cascode structure as current source.
In example 13, the quantizer 120 corresponds to a multibit quantizer.
In example 14, the integrator 110 corresponds to or implements a bandpass filter.
In example 15, the delta sigma analog-to-digital converter 100 corresponds to a bandpass delta sigma analog-to-digital converter 100.
In example 16, the differential radio frequency current signal has a carrier frequency in a transmission band of the differential radio frequency current signal.
Example 17 is a radio front-end 200 comprising a delta sigma analog-to-digital converter 100a according to one of the preceding examples 1 to 16.
In example 18, the radio front-end 200 further comprises a single-ended to differential low-noise amplifier 210 configured to provide the differential radio frequency current signal.
In example 19, the radio front-end 200 further comprises a de-coupling capacitor 220a; 220b for each differential signal branch of the differential radio frequency current signal between the single-ended to differential low-noise amplifier 210 and the integrator 110.
In example 20, the radio front-end 200 further comprises a digital frontend 230 with an input for the digital voltage signal.
Example 21 is a radio receiver 700 comprising a radio front-end 200a according to one of the examples 17 to 20.
Example 22 is a mobile terminal 810 comprising a radio front-end 200b according to one of the examples 17 to 20.
Example 23 is a base station 820 comprising a radio front-end 200c according to one of the examples 17 to 20.
Example 24 is an apparatus 100 for analog-to-digital converting a differential radio frequency current signal. The apparatus comprises a means for integration 110 with a differential input for a differential current signal, and a differential output for a differential voltage signal. The apparatus further comprises a means for quantization 120 with a differential input for the differential voltage signal and a differential output for a digitalized signal. The apparatus further comprises two or more means 130 for digital-to-analog conversion, each with a differential input for the digitalized signal and a differential output for a differential feedback current signal, resulting in two or more separate differential feedback current signals. The differential current signal is based on the two or more separate differential feedback current signals and the differential radio frequency current signal.
In example 25, the means for integration 110 comprises one or more differential stages of the means for integration, wherein each differential stage of the one or more differential stages comprises a means for resonating.
In example 26, each means for resonating of the one or more differential stages comprises an active inductor and a capacitor.
In example 27, the means for integration 110 comprises two or more differential stages of the means for integration, wherein the two or more differential stages are separated by means for differential buffering.
In example 28, an output of a means for differential buffering is coupled to a differential transconductance amplifying means, wherein the two or more stages are separated by the means for differential buffering and the means for differential transconductance amplifying, and wherein the means for differential transconductance amplifying is configured to generate the differential current signal for a subsequent stage based on a differential voltage output of the means for differential buffering.
In example 29, the means for differential buffering each comprise a differential inverter structure with a regulated common-mode output voltage.
In example 30, the number of means for digital-to-analog conversion of the two or more means 130 for digital-to-analog conversion is at least twice the number of differential stages of the means for integration plus one.
In example 31, the two or more means 130 for digital-to-analog conversion comprise at least two means for differential digital-to-analog conversion for each stage of the integrating means (110), wherein the at least two means for differential digital-to-analog conversion for each stage have mutually different pulse-shaping properties.
In example 32, each digital-to-analog conversion means of the two means for differential digital-to-analog conversion for each stage of the integrating means (110) is configured to provide the separate differential feedback current signal for the means for resonating of its respective stage of the means for integration.
In example 33, the two or more means 130 for digital-to-analog conversion comprise one means for differential non-return-to-zero digital-to-analog conversion being delayed by a half clock cycle compared to other differential digital-to-analog conversion means of the two or more means 130 for digital-to-analog conversion, wherein the one means for non-return-to-zero differential digital-to-analog conversion is configured to provide the differential feedback current signal for the last stage of the one or more stages of the means for integration.
In example 34, the means for integration 110 comprises a means for differential voltage amplification at the output of the means for integration 110 to generate the differential voltage signal.
In example 35, the means for differential voltage amplification corresponds to a means for fully differential amplification comprising a cascode structure as current source.
In example 36, the means for quantization 120 corresponds to a multibit means for quantization.
In example 37, the means for integration 110 corresponds to or implements a means for band-pass filtering.
In example 38, the apparatus 100 corresponds to a means for bandpass delta sigma analog-to-digital conversion 100.
In example 39, the differential radio frequency current signal has a carrier frequency in a transmission band of the differential radio frequency current signal.
Example 40 is a radio front-end apparatus 200 for a radio front-end analog-to-digital conversion comprising an apparatus 100 for analog-to-digital converting a differential radio frequency current signal according to one of the examples 24 - 39.
In example 41, the radio front-end apparatus 200 further comprises a means for single-ended to differential low-noise amplification 210 configured to provide the differential radio frequency current signal.
In example 42, the radio front-end apparatus 200 further comprises a means for decoupling 220a; 220b for each differential signal branch of the differential radio frequency current signal between the means for single-ended to differential low-noise amplification 210 and the means for integration 110.
In example 43, the radio front-end apparatus 200 further comprises a digital frontend means 230 with an input for the digital voltage signal.
Example 44 is a method for delta sigma analog-to-digital converting a differential radio frequency current signal. The method comprises integrating a differential current signal to obtain a differential voltage signal. The method further comprises quantizing the differential voltage signal to obtain a digitalized signal. The method further comprises digital-to-analog-converting the digitalized signal to obtain two or more separate differential feedback current signals. The differential current signal is based on the two or more separate differential feedback current signals and the differential radio frequency current signal.
In example 45, the integrating comprises one or more differential integrating stages, wherein each differential integrating stage of the one or more differential integrating stages comprises using a resonator.
In example 46, each using of a resonator of the one or more differential integrating stages comprises using an active inductor and a capacitor.
In example 47, the integrating comprises two or more differential integrating stages, wherein the two or more differential integrator stages are separated by differential buffering.
In example 48, the two or more integrating stages are separated by the differential buffering and differential transconductance amplifying, wherein the differential transconductance amplifying generates the differential current signal for a subsequent integrating stage based on a voltage output of the differential buffering.
In example 49, the digital-to-analog-converting comprises at least twice differential digital-to-analog converting for each integrating stage, wherein the at least twice differential digital-to-analog converting for each integrating stage have mutually different pulse-shaping properties.
In example 50, each differential digital-to-analog converting of the at least twice differential digital-to-analog converting for each integrating stage provides the separate differential feedback current signal for its respective integration stage.
In example 51, the digital-to-analog-converting comprises once differential non-return-to-zero digital-to-analog concerting being delayed by a half clock cycle compared to other differential digital-to-analog conversions of the separate differential feedback current signals, wherein the one non-return-to-zero differential digital-to-analog conversion provides the differential feedback current signal for the last integration stage of the one or more integration stages.
In example 52, the integrating comprises differential voltage amplifying to generate the differential voltage signal.
In example 53, the quantizing corresponds to a multibit quantizing.
In example 54, the integrating corresponds to or comprises bandpass filtering.
In example 55, the method for delta sigma analog-to-digital converting corresponds to a method for bandpass delta sigma analog-to-digital converting.
In example 56, the differential radio frequency current signal has a carrier frequency in a transmission band of the differential radio frequency current signal.
Example 57 is a radio front-end method for analog-to-digital converting, comprising a method for delta sigma analog-to-digital converting a differential radio frequency current signal according to one of the examples 44 to 56.
In example 58, the radio front-end method further comprises single-ended to differential low-noise amplifying to provide the differential radio frequency current signal.
In example 59, the radio front-end method further comprises comprising decoupling each differential signal branch of the differential radio frequency current signal between the single-ended to differential low-noise amplifying and the integrating.
In example 60, the radio front-end method further comprises inputting the digital voltage signal into a digital frontend.
Example 61 is a mobile terminal 810 comprising a radio front-end apparatus 200b according to one of the examples 40 to 43.

Examples may further be or relate to a computer program having a program code for performing one or more of the above methods, when the computer program is executed on a computer or processor. Steps, operations or processes of various above-described methods may be performed by programmed computers or processors. Examples may also cover program storage devices such as digital data storage media, which are machine, processor or computer readable and encode machine-executable, processor-executable or computer-executable programs of instructions. The instructions perform or cause performing some or all of the acts of the above-described methods. The program storage devices may comprise or be, for instance, digital memories, magnetic storage media such as magnetic disks and magnetic tapes, hard drives, or optically readable digital data storage media. Further examples may also cover computers, processors or control units programmed to perform the acts of the above-described methods or (field) programmable logic arrays ((F)PLAs) or (field) programmable gate arrays ((F)PGAs), programmed to perform the acts of the above-described methods.

The description and drawings merely illustrate the principles of the disclosure. Furthermore, all examples recited herein are principally intended expressly to be only for pedagogical purposes to aid the reader in understanding the principles of the disclosure and the concepts contributed by the inventor(s) to furthering the art. All statements herein reciting principles, aspects, and examples of the disclosure, as well as specific examples thereof, are intended to encompass equivalents thereof.

A functional block denoted as "means for ..." performing a certain function may refer to a circuit that is configured to perform a certain function. Hence, a "means for s.th." may be implemented as a "means configured to or suited for s.th.", such as a device or a circuit configured to or suited for the respective task.

Functions of various elements shown in the figures, including any functional blocks labeled as "means", "means for providing a sensor signal", "means for generating a transmit signal.", etc., may be implemented in the form of dedicated hardware, such as "a signal provider", "a signal processing unit", "a processor", "a controller", etc. as well as hardware capable of executing software in association with appropriate software. When provided by a processor, the functions may be provided by a single dedicated processor, by a single shared processor, or by a plurality of individual processors, some of which or all of which may be shared. However, the term "processor" or "controller" is by far not limited to hardware exclusively capable of executing software, but may include digital signal processor (DSP) hardware, network processor, application specific integrated circuit (ASIC), field programmable gate array (FPGA), read only memory (ROM) for storing software, random access memory (RAM), and nonvolatile storage. Other hardware, conventional and/or custom, may also be included.

A block diagram may, for instance, illustrate a high-level circuit diagram implementing the principles of the disclosure. Similarly, a flow chart, a flow diagram, a state transition diagram, a pseudo code, and the like may represent various processes, operations or steps, which may, for instance, be substantially represented in computer readable medium and so executed by a computer or processor, whether or not such computer or processor is explicitly shown. Methods disclosed in the specification or in the claims may be implemented by a device having means for performing each of the respective acts of these methods.

It is to be understood that the disclosure of multiple acts, processes, operations, steps or functions disclosed in the specification or claims may not be construed as to be within the specific order, unless explicitly or implicitly stated otherwise, for instance for technical reasons. Therefore, the disclosure of multiple acts or functions will not limit these to a particular order unless such acts or functions are not interchangeable for technical reasons. Furthermore, in some examples a single act, function, process, operation or step may include or may be broken into multiple sub-acts, -functions, -processes, -operations or -steps, respectively. Such sub acts may be included and part of the disclosure of this single act unless explicitly excluded.

Furthermore, the following claims are hereby incorporated into the detailed description, where each claim may stand on its own as a separate example. While each claim may stand on its own as a separate example, it is to be noted that - although a dependent claim may refer in the claims to a specific combination with one or more other claims - other examples may also include a combination of the dependent claim with the subject matter of each other dependent or independent claim. Such combinations are explicitly proposed herein unless it is stated that a specific combination is not intended. Furthermore, it is intended to include also features of a claim to any other independent claim even if this claim is not directly made dependent to the independent claim.

## Claims

1. An apparatus (100) for analog-to-digital converting a differential radio frequency current signal, comprising
a means for integration (110) with a differential input for a differential current signal, and a differential output for a differential voltage signal;
a means for quantization (120) with a differential input for the differential voltage signal and a differential output for a digitalized signal;
two or more means (130) for digital-to-analog conversion, each with a differential input for the digitalized signal and a differential output for a differential feedback current signal, resulting in two or more separate differential feedback current signals,
wherein the differential current signal is based on the two or more separate differential feedback current signals and the differential radio frequency current signal.

2. The apparatus (100) according to claim 1, wherein the means for integration (110) comprises one or more differential stages of the means for integration, wherein each differential stage of the one or more differential stages comprises a means for resonating.

3. The apparatus (100) according to claim 2, wherein each means for resonating of the one or more differential stages comprises an active inductor and a capacitor.

4. The apparatus (100) according to one of the claims 2 or 3, wherein the means for integration (110) comprises two or more differential stages of the means for integration, wherein the two or more differential stages are separated by means for differential buffering.

5. The apparatus (100) according to claim 4, wherein an output of a means for differential buffering is coupled to a means for differential transconductance amplifying, wherein the two or more stages are separated by the means for differential buffering and the means for differential transconductance amplifying, and wherein the means for differential transconductance amplifying is configured to generate the differential current signal for a subsequent stage based on a differential voltage output of the means for differential buffering.

6. The apparatus (100) according to one of the claims 4 or 5, wherein the means for differential buffering each comprise a differential inverter structure with a regulated common-mode output voltage.

7. The apparatus (100) according to one of the claims 2 to 6, wherein the number of means for digital-to-analog conversion of the two or more means (130) for digital-to-analog conversion is at least twice the number of differential stages of the means for integration plus one.

8. The apparatus (100) according to one of the claims 2 to 7, wherein the two or more means (130) for digital-to-analog conversion comprise at least two means for differential digital-to-analog conversion for each stage of the integrating means (110), wherein the at least two means for differential digital-to-analog conversion for each stage have mutually different pulse-shaping properties.

9. The apparatus (100) according to claim 8, wherein each digital-to-analog conversion means of the two means for differential digital-to-analog conversion for each stage of the integrating means (110) is configured to provide the separate differential feedback current signal for the means for resonating of its respective stage of the means for integration.

10. The apparatus (100) according to one of the previous claims, wherein the two or more means (130) for digital-to-analog conversion comprise one means for differential non-return-to-zero digital-to-analog conversion being delayed by a half clock cycle compared to other differential digital-to-analog conversion means of the two or more means (130) for digital-to-analog conversion, wherein the one means for non-return-to-zero differential digital-to-analog conversion is configured to provide the differential feedback current signal for the last stage of the one or more stages of the means for integration.

11. The apparatus (100) according to one of the previous claims, wherein the means for integration (110) comprises a means for differential voltage amplification at the output of the means for integration (110) to generate the differential voltage signal.

12. A radio front-end apparatus (200) for a radio front-end analog-to-digital conversion comprising an apparatus (100) for analog-to-digital converting a differential radio frequency current signal according to one of the previous claims.

13. A mobile terminal (810) comprising a radio front-end apparatus (200b) according to claim 12.

14. A method for delta sigma analog-to-digital converting a differential radio frequency current signal, comprising
integrating a differential current signal to obtain a differential voltage signal;
quantizing the differential voltage signal to obtain a digitalized signal; and
digital-to-analog-converting the digitalized signal to obtain two or more separate dif ferential feedback current signals,
wherein the differential current signal is based on the two or more separate differential feedback current signals and the differential radio frequency current signal.

15. The method according to claim 14, wherein the integrating comprises one or more differential integrating stages, wherein each differential integrating stage of the one or more differential integrating stages comprises using a resonator.
